# EUROPEAN PATENT APPLICATION

(11) **EP 4 776 156 A1**
(43) Date of publication of application: **15.07.2026**
(21) Application number: 25203233.9
(22) Date of filing: 19.09.2025
(51) Int. Cl.: G06F 16/583, G06F 16/901, G06F 16/51

(54) **METHODS AND SYSTEMS FOR GENERATING DESIGN COMPONENT KNOWLEDGE GRAPH AND DESIGN COMPONENT RETRIEVAL THEREOF**

(30) Priority: 13.01.2025 IN 202521002842
(71) Applicant: Tata Consultancy Services Limited, Maharashtra (IN)
(72) Inventor: PRAKASH, Chandra, 500081 Hyderabad, Telangana (IN); MOHAN, Akash, 600113 Chennai, Tamil Nadu (IN); GUDURU, Karthik, 500081 Hyderabad, Telangana (IN); SARKAR, Artha, 700046 Kolkata, West Bengal (IN); SOM, Sankha Subhra, 500081 Hyderabad, Telangana (IN); DAHAKE, Shishir, 411057 Pune, Maharashtra (IN); KARANDE, Shirish Subhash, 411057 Pune, Maharashtra (IN); SRIVASTAVA, Vivek, 110001 New Delhi, Delhi (IN)
(74) Representative: Goddar, Heinz J.

(57) **Abstract**

The disclosure relates generally to methods and systems for generating design component knowledge graph and design component retrieval from the same. Conventional techniques that utilize customizable knowledge graphs for retrieval of the design components are very limited in the digital design domain. The methods and systems of the present disclosure generate the design component knowledge graph using filtered captions generated for the design component objects. The design component objects are of the design components and are selected using an instruction triplet generated based on a user requirement query of the digital design that the user is interested in. Then, a plurality of captions is generated and filtered using a semantic filtering to obtain the filtered captions. Then the design component knowledge graph is queried with the user input to retrieve the design components that best suit the design requirement of the user.

## Description

### CROSS-REFERENCE TO RELATED APPLICATIONS AND PRIORITY

The present application claims priority from Indian application no. 202521002842, filed on January 13, 2025.

### TECHNICAL FIELD

The disclosure herein generally relates to digital design, and, more particularly, to methods and systems for generating design component knowledge graph and design component retrieval thereof.

### BACKGROUND

In the dynamic fields of digital design such as fashion design, interior design, and so on, customers may be interested in various designs according to their taste, look and feel requirements. This design process demands significant time and effort, which can hinder responsiveness to rapidly evolving customer preferences. Thus, meeting the interests and requirements of these designs is quite challenging and dynamic in nature as the interests may vary from person to person. Customization is very essential because customer tastes and design trends change swiftly. Hence, facilitating the customization and bringing the flexibility in accessing relevant design components present in the given design is very crucial. For example, in the case of interior design, the design components such as a sofa, chairs, tables, television (TV) wall, and so on, to be customized based on the interests of the customer.

Knowledge graphs are a powerful technology that organizes the data from multiple sources and captures the semantics of a particular domain using a set of definitions of concepts, their properties, relations between them, in the form of nodes (entities) and edges (relationships). Hence, the knowledge graphs in the field of digital design allow to arrange the design components in the form of nodes and their relations in the form of edges to bring the digital structure of the given design. Further, the knowledge graphs can be leveraged for search and retrieval of the design components of the interest based on the design requirement of the user.

Conventional knowledge graphs while powerful often exhibit rigidity and require extensive manual annotations of nodes and relationships to accommodate changes, which is time-consuming. Hence, transforming the large volumes of image databases associated with the digital designs into the knowledge graphs is quite challenging and may not be accurate without manual annotations. Thus, conventional techniques that utilize customizable knowledge graphs for retrieval of the design components are very limited in the digital design domain. Further, as the database of design images grows, retrieving relevant design components directly from the images becomes increasingly challenging.

### SUMMARY

Embodiments of the present disclosure present technological improvements as solutions to one or more of the above-mentioned technical problems recognized by the inventors in conventional systems.

In an aspect, a processor-implemented method for generating design component knowledge graph and design component retrieval is provided. The method comprising: receiving a plurality of design images associated with a design, from a design image repository, wherein each of the plurality of design images comprises one or more design components; extracting a plurality of design component objects from the plurality of design images, using a design component detection model; selecting one or more design component objects out of the plurality of design component objects based on a design requirement input, using a component selection model; pre-processing the one or more design component objects to obtain one or more pre-processed design component objects, using one or more pre-processing techniques; obtaining one or more textual descriptions from the one or more pre-processed design component objects associated with the one or more design components, using an image description model and a semantic filtering; generating a design component knowledge graph associated with the design, from the one or more textual descriptions, using one or more knowledge graph generation models; receiving an input query associated with the design from a user, wherein the input query is one of a text, and an image; transforming the input query associated with the design into a transformed input query associated with the design component, using a query transformation model; and retrieving the one or more design component objects associated with the design, from the design component knowledge graph, based on the transformed input query.

**In** another aspect, a system for generating design component knowledge graph and design component retrieval is provided. The system includes: a memory storing instructions; one or more Input/Output (I/O) interfaces; and one or more hardware processors coupled to the memory via the one or more I/O interfaces, wherein the one or more hardware processors are configured by the instructions to: receive a plurality of design images associated with a design, from a design image repository, wherein each of the plurality of design images comprises one or more design components; extract a plurality of design component objects from the plurality of design images, using a design component detection model; select one or more design component objects out of the plurality of design component objects based on a design requirement input, using a component selection model; pre-process the one or more design component objects to obtain one or more pre-processed design component objects, using one or more pre-processing techniques; obtain one or more textual descriptions from the one or more pre-processed design component objects associated with the one or more design components, using an image description model and a semantic filtering; generate a design component knowledge graph associated with the design, from the one or more textual descriptions, using one or more knowledge graph generation models; receive an input query associated with the design from a user, wherein the input query is one of a text, and an image; transform the input query associated with the design into a transformed input query associated with the design component, using a query transformation model; and retrieve the one or more design component objects associated with the design, from the design component knowledge graph, based on the transformed input query.

In yet another aspect, there are provided one or more non-transitory machine-readable information storage mediums comprising one or more instructions which when executed by one or more hardware processors cause: receiving a plurality of design images associated with a design, from a design image repository, wherein each of the plurality of design images comprises one or more design components; extracting a plurality of design component objects from the plurality of design images, using a design component detection model; selecting one or more design component objects out of the plurality of design component objects based on a design requirement input, using a component selection model; pre-processing the one or more design component objects to obtain one or more pre-processed design component objects, using one or more pre-processing techniques; obtaining one or more textual descriptions from the one or more pre-processed design component objects associated with the one or more design components, using an image description model and a semantic filtering; generating a design component knowledge graph associated with the design, from the one or more textual descriptions, using one or more knowledge graph generation models; receiving an input query associated with the design from a user, wherein the input query is one of a text, and an image; transforming the input query associated with the design into a transformed input query associated with the design component, using a query transformation model; and retrieving the one or more design component objects associated with the design, from the design component knowledge graph, based on the transformed input query.

In an embodiment, selecting the one or more design component objects out of the plurality of design component objects based on the design requirement input, using the component selection model, comprises: receiving the design requirement input associated with the design from a user, selection criteria, and an exemplary design component object set associated with the selection criteria; generating an instruction triplet associated to the design requirement input, based on the selection criteria and the exemplary design component objects set associated with the selection criteria, using a few-shot prompting and a large language model (LLM); and selecting the one or more design component objects out of the plurality of design component objects, using the component selection model and the instruction triplet.

In an embodiment, obtaining the one or more textual descriptions from the one or more pre-processed design component objects associated with the one or more design components, using the image description model and the semantic filtering, comprises: generating a plurality of textual descriptions from the one or more pre-processed design component objects, using the image description model; and obtaining the one or more textual descriptions associated with the one or more design components, out of the plurality of textual descriptions using the semantic filtering.

In an embodiment, generating the design component knowledge graph associated with the design, from the one or more textual descriptions, using the one or more knowledge graph generation models, comprises: extracting (i) one or more entities and (ii) one or more relationships between the one or more entities from each of the one or more textual descriptions, using an entity relationship extraction model; and generating the design component knowledge graph associated with the design, from (i) the one or more entities, (ii) the one or more relationships between the one or more entities, and (iii) an associated image identifier of each of the plurality of design component images, using the one or more knowledge graph generation models.

It is to be understood that both the foregoing general description and the following detailed description are exemplary and explanatory only and are not restrictive of the invention, as claimed.

### BRIEF DESCRIPTION OF THE DRAWINGS

The accompanying drawings, which are incorporated in and constitute a part of this disclosure, illustrate exemplary embodiments and, together with the description, serve to explain the disclosed principles:
FIG. 1 is an exemplary block diagram of a system for generating design component knowledge graph and design component retrieval, in accordance with some embodiments of the present disclosure.
FIG. 2 is an exemplary block diagram illustrating modules of the system of FIG. 1, for generating design component knowledge graph and design component retrieval, in accordance with some embodiments of the present disclosure.
FIGS. 3A and 3B illustrate exemplary flow diagrams of a processor-implemented method for generating design component knowledge graph and design component retrieval, using the system of FIG. 1, in accordance with some embodiments of the present disclosure.
FIG. 4 is a flowchart showing the steps for selecting one or more design component objects out of the plurality of design component objects, in accordance with some embodiments of the present disclosure.
FIG. 5 is a flowchart showing the steps for obtaining the one or more textual descriptions from the one or more pre-processed design component objects, in accordance with some embodiments of the present disclosure.
FIG. 6 is a flowchart showing the steps for generating the design component knowledge graph associated with the design, from the one or more textual descriptions, in accordance with some embodiments of the present disclosure.
FIG. 7 shows an exemplary design component knowledge graph generated for an exemplary interior design, in accordance with some embodiments of the present disclosure.

### DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments.

The terms or expressions such as 'user', 'customer, are used interchangeably based on the context and the application of the present disclosure, otherwise such terms or expressions refer to a person who is in need of the particular design.

Customization in digital design such as fashion design, interior design is very essential because customer tastes and design trends change swiftly. Conventional techniques that utilize customizable knowledge graphs for retrieval of the design components are very limited in the digital design domain. Further, as the database of design images grows, retrieving relevant design components directly from the images becomes increasingly challenging.

The present disclosure solves the technical problems in the art with the methods and systems for generating design component knowledge graph and design component retrieval. The methods and systems of the present disclosure generate the design component knowledge graph using the captions generated from the design component objects. The design component objects are of the design components and are filtered using semantic filtering. The semantic filtering is employed based on the user requirement query of the digital design that the user is interested in. Then the design component knowledge graph is queried with the user input to retrieve the design components that best suit the design requirement of the user.

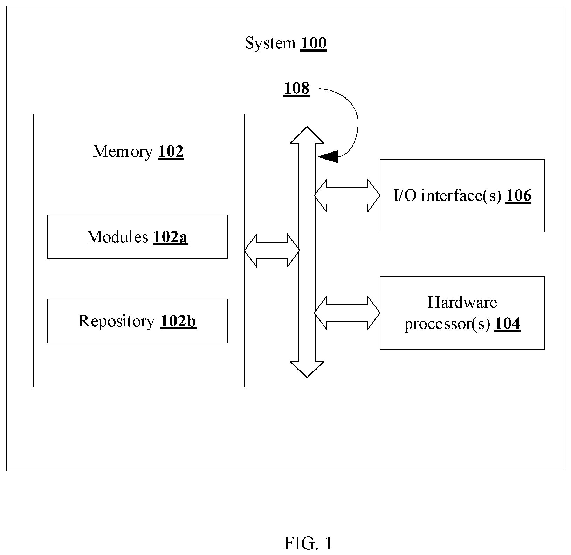

Referring now to the drawings, and more particularly to FIG. 1 through FIG. 7, where similar reference characters denote corresponding features consistently throughout the figures, there are shown preferred embodiments, and these embodiments are described in the context of the following exemplary systems and/or methods.

FIG. 1 is an exemplary block diagram of a system 100 for generating design component knowledge graph and design component retrieval, in accordance with some embodiments of the present disclosure. In an embodiment, the system 100 includes or is otherwise in communication with one or more hardware processors 104, communication interface device(s) or input/output (I/O) interface(s) 106, and one or more data storage devices or memory 102 operatively coupled to the one or more hardware processors 104. The one or more hardware processors 104, the memory 102, and the I/O interface(s) 106 may be coupled to a system bus 108 or a similar mechanism.

The I/O interface(s) 106 may include a variety of software and hardware interfaces, for example, a web interface, a graphical user interface (GUI), and the like. The I/O interface(s) 106 may include a variety of software and hardware interfaces, for example, interfaces for peripheral device(s), such as a keyboard, a mouse, an external memory, a plurality of sensor devices, a printer and the like. Further, the I/O interface(s) 106 may enable the system 100 to communicate with other devices, such as web servers and external databases.

The I/O interface(s) 106 can facilitate multiple communications within a wide variety of networks and protocol types, including wired networks, for example, local area network (LAN), cable, etc., and wireless networks, such as Wireless LAN (WLAN), cellular, or satellite. For the purpose, the I/O interface(s) 106 may include one or more ports for connecting a number of computing systems with one another or to another server computer. Further, the I/O interface(s) 106 may include one or more ports for connecting a number of devices to one another or to another server.

The one or more hardware processors 104 may be implemented as one or more microprocessors, microcomputers, microcontrollers, digital signal processors, central processing units, state machines, logic circuitries, and/or any devices that manipulate signals based on operational instructions. Among other capabilities, the one or more hardware processors 104 are configured to fetch and execute computer-readable instructions stored in the memory 102. In the context of the present disclosure, the expressions 'processors' and 'hardware processors' may be used interchangeably. In an embodiment, the system 100 can be implemented in a variety of computing systems, such as laptop computers, portable computers, notebooks, hand-held devices, workstations, mainframe computers, servers, a network cloud and the like.

The memory 102 may include any computer-readable medium known in the art including, for example, volatile memory, such as static random access memory (SRAM) and dynamic random access memory (DRAM), and/or non-volatile memory, such as read only memory (ROM), erasable programmable ROM, flash memories, hard disks, optical disks, and magnetic tapes. In an embodiment, the memory 102 includes a plurality of modules 102a and a repository 102b for storing data processed, received, and generated by one or more of the plurality of modules 102a. The plurality of modules 102a may include routines, programs, objects, components, data structures, and so on, which perform particular tasks or implement particular abstract data types.

The plurality of modules 102a may include programs or computer-readable instructions or coded instructions that supplement applications or functions performed by the system 100. The plurality of modules 102a may also be used as, signal processor(s), state machine(s), logic circuitries, and/or any other device or component that manipulates signals based on operational instructions. Further, the plurality of modules 102a can be used by hardware, by computer-readable instructions executed by the one or more hardware processors 104, or by a combination thereof. In an embodiment, the plurality of modules 102a can include various sub-modules (not shown in FIG. 1). Further, the memory 102 may include information pertaining to input(s)/output(s) of each step performed by the processor(s) 104 of the system 100 and methods of the present disclosure.

The repository 102b may include a database or a data engine. Further, the repository 102b amongst other things, may serve as a database or includes a plurality of databases for storing the data that is processed, received, or generated as a result of the execution of the plurality of modules 102a. Although the repository 102b is shown internal to the system 100, it will be noted that, in alternate embodiments, the repository 102b can also be implemented external to the system 100, where the repository 102b may be stored within an external database (not shown in FIG. 1) communicatively coupled to the system 100. The data contained within such external database may be periodically updated. For example, data may be added into the external database and/or existing data may be modified and/or non-useful data may be deleted from the external database. In one example, the data may be stored in an external system, such as a Lightweight Directory Access Protocol (LDAP) directory and a Relational Database Management System (RDBMS). In another embodiment, the data stored in the repository 102b may be distributed between the system 100 and the external database.

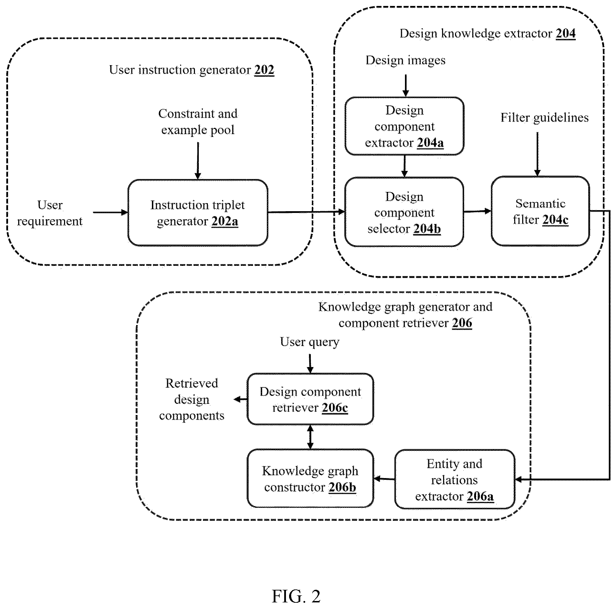

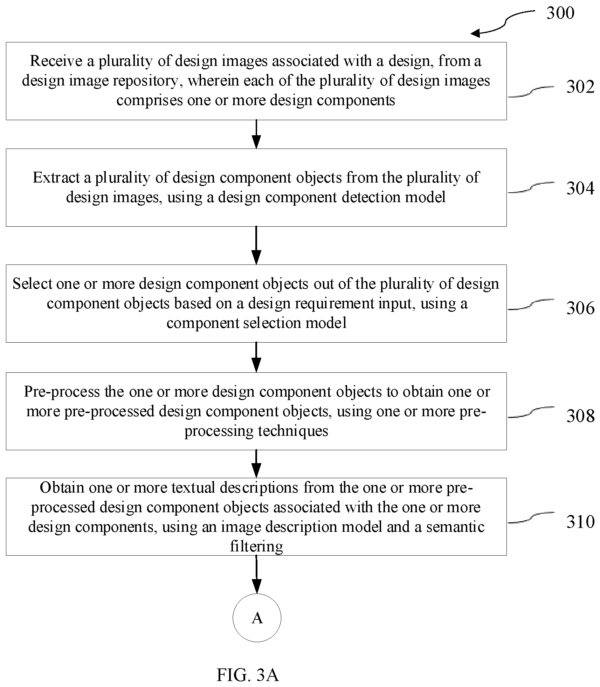

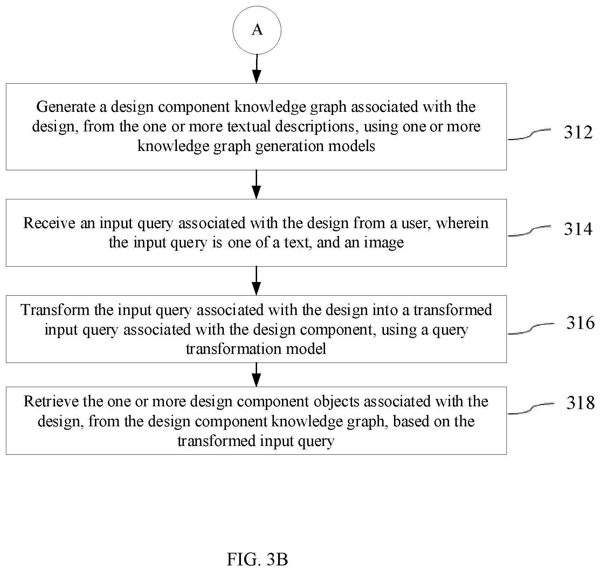

Referring collectively to FIG. 2 and FIGS. 3A and 3B, components and functionalities of the system 100 are described in accordance with an example embodiment of the present disclosure. For example, FIG. 2 is an exemplary block diagram illustrating the plurality of modules 102a of the system 100 of FIG. 1, for generating design component knowledge graph and design component retrieval, in accordance with some embodiments of the present disclosure. In an embodiment, the plurality of modules 102a include a user instruction generator 202, a design knowledge extractor 204, and a knowledge graph generator and component retriever 206. The user instruction generator 202 further includes an instruction triplet generator 202a. The design knowledge extractor 204 further includes a design component extractor 204a, a design component selector 204b, and a semantic filter 204c. The knowledge graph generator and component retriever 206 further includes an entity and relations extractor 206a, a knowledge graph constructor 206b, and a design component retriever 206c.

For example, FIGS. 3A and 3B illustrate exemplary flow diagrams of a processor-implemented method 300 for generating design component knowledge graph and design component retrieval, using the system 100 of FIG. 1, in accordance with some embodiments of the present disclosure. Although steps of the method 300 including process steps, method steps, techniques or the like may be described in a sequential order, such processes, methods, and techniques may be configured to work in alternate orders. In other words, any sequence or order of steps that may be described does not necessarily indicate a requirement that the steps be performed in that order. The steps of processes described herein may be performed in any practical order. Further, some steps may be performed simultaneously, or some steps may be performed alone or independently.

At step 302 of the method 300, the one or more input/output (I/O) interfaces 106 of the system 100 are configured to receive a plurality of design images associated with a design. The design is one of digital designs that the user or the customer is looking at. For example, digital designs include but are not limited to fashion design, industrial design, manufacturing design, and interior design. The plurality of design images includes the number of digital images of the corresponding design. For example, the number of design images for the interior design may be 1000, however the number may vary for each design.

Each of the plurality of design images associated with the design includes one or more design components. The one or more design components includes the components that are present in the given design. For example, the one or more digital components of the interior design includes a sofa, chairs, tables, television (TV) wall, and so on. More specifically, each design image may not include all the design components, but may contain some of the design components, however the design components may present in different variations such as style, design, size, and so on. For example, an exemplary interior design may include only the sofa, chairs, and tables. Another exemplary interior design includes only sofa, chairs, television (TV) wall, and so on, however in different variations.

The plurality of design images associated with the given design are stored in a design image repository from which the required design images are received. **In** an embodiment, the design image repository is a database or any other digital storage that may be present in the repository 102b of the system 100.

At step 304 of the method 300, the one or more hardware processors 104 of the system 100 are configured to extract a plurality of design component objects from the plurality of design images of the given design. The plurality of design component objects are the images which refer to the component objects that are present in each of the plurality of design images. For example, if the design the interior design, then the plurality of design component objects are the images of the design components such as a sofa, chairs, tables, television (TV) wall, and so on. However, there may be multiple instances of the design component objects as they may be present in multiple design images in same of different variations. In an embodiment, the design component extractor 204a of the design knowledge extractor 204 is configured to extract the plurality of design component objects from the plurality of design images.

In the present disclosure, a design component detection model is employed to extract one or more design component objects from each design image, to obtain the plurality of design component objects from the plurality of design images. In an embodiment, the design component detection model is an object detection model such as a pre-trained detr-resnet-50 model, an image recognition model, a bounding box identification model such as meta segment anything model (SAM), and so on.

In an embodiment, the design component detection model is configured to perform a predefined extraction process to extract the one or more design component objects from each of the plurality of design images. The predefined extraction process processes objects detected in an image, skips those that are too small, and saves the cropped images of sufficiently large objects with filenames that include a confidence score. The predefined extraction process with exemplary sequential steps is explained below:
- Area check: This operation checks if an object in an image is smaller than a specified minimum area percentage (min_area_percentage). This is done by comparing area_percentage (the size of the object relative to the whole image) to min_area_percentage.
- Skip small objects: If the area_percentage of the object is smaller than the min_area_percentage, then the corresponding objects are removed/skipped.
- Crop the object: If the object passes the area check, it proceeds to crop the object from the image using a specified bounding box (box). This involves extracting just the part of the image that contains the object.
- Generate output filename: The operation creates a filename for the cropped object. This filename includes a base name (base_filename) and appends the confidence level of the object detection (formatted to three decimal places) as part of the filename. The confidence level indicates how certain the object is correctly identified.
- Save the cropped image: The cropped image is then saved to a specified directory (output_dir) with the generated filename. This involves constructing the full path (output_path) for saving and then writing the cropped image to this location.

At step 306 of the method 300, the one or more hardware processors 104 of the system 100 are configured to select one or more design component objects out of the plurality of design component objects extracted at step 304 of the method 300. A component selection model is employed to select one or more design component objects out of the plurality of design component objects, based on the design requirement input received from the user. The user provides the design requirement input which may include the design components, their style, variation, and their combination that should be present in the design that the user is interested in.

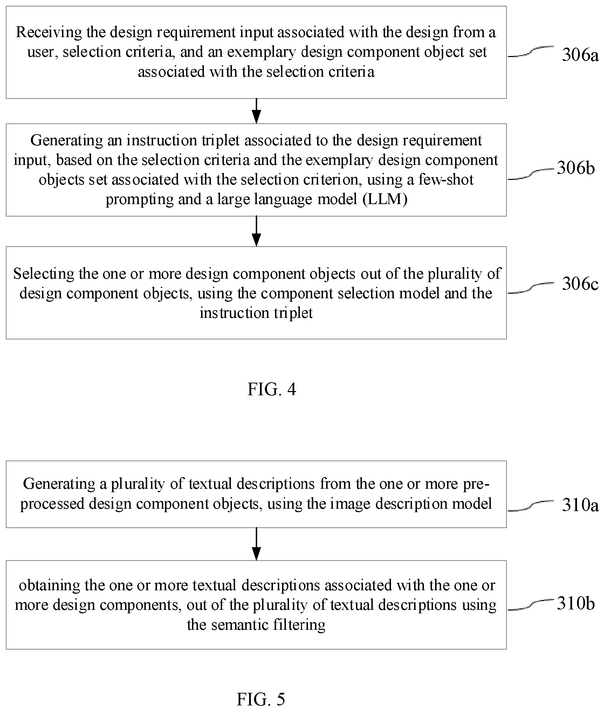

FIG. 4 is a flowchart showing the steps for selecting one or more design component objects out of the plurality of design component objects, in accordance with some embodiments of the present disclosure. As shown in FIG. 4, selecting the one or more design component objects out of the plurality of design component objects, is explained through steps 306a to 306c.

At step 306a, the design requirement input associated with the design is received either from the user or a pre-configured agent such as a chatbot. Further selection criteria, and an exemplary design component object set associated with the selection criteria are also received. In an embodiment, the selection criteria refer to a plurality of selection criteria that are present in the repository. Each of the selection criterions refer to the design parameters that the user is interested in such as functionality, aesthetics, creativity, harmony, sustainability, ergonomics, cultural relevance, durability, cost-effectiveness, safety, and so on. Each of the selection criterions contains a subset of design component object set that is part of the exemplary design component object set. In an embodiment, the selection criteria and the exemplary design component object set are stored in the constraint and the example pool.

Each of the mentioned design parameters is explained below:
- Functionality: The design component should serve a practical purpose and enhance the usability of the space.
- Aesthetics: The design component should be visually appealing and align well with the overall design theme.
- Creativity: The design component should incorporate creative or unique elements that inspire new ideas.
- Harmony: The design component should not add to clutter. It should include the complete object, not just a partial or cropped version.
- Sustainability: Whether the design component is made from eco-friendly materials. Consider if the design component promotes energy efficiency or resource conservation.
- Ergonomics: Whether the design component is designed with human use in mind, providing comfort and efficiency.
- Cultural Relevance: Whether the design component reflects or respects cultural influences.
- Durability: Whether the design component can withstand wear and tear, making it a practical choice for long-term use.
- Cost-effectiveness: Whether the design component provides good value for its cost
- Safety: Ensure the design component does not pose any safety risks to humans.

The subset of design component object set associated with each selection criteria is a sub-set of positive design component objects and a sub-set of negative design component objects, and corresponding to given design parameters as stated above. The sub-set of positive design component objects are the plurality of design component objects that are usually present in the design given the design parameters defined in the selection criterion. Similarly, the sub-set of negative design component objects are the plurality of design component objects that are usually not present in the design given the design parameters defined in the selection criterion.

At step 306b, an instruction triplet associated to the design requirement input is generated based on the selection criteria, and the exemplary design component objects set associated with the selection criteria. A few-shot prompting and a large language model (LLM) are employed to generate the instruction triplet corresponding to the design requirement input received from the user at step 306a. The few-shot prompting enables the user to define a prompt for the large language model (LLM) such as GPT, for generating the instruction triplet associated to the design requirement input. In an embodiment, the instruction triplet generator 202a of the user instruction generator 202 is configured to generate the instruction triplet associated with the design requirement input.

In an embodiment, the instruction triplet associated to the design requirement input includes a (i) a role, (ii) one or more selection criterions for the design components out of the selection criteria, and (iii) one or more positive and negative design component objects among the exemplary design component object set. In an embodiment, the role defines the objective of the user as presented in the design requirement input. The one or more selection criterions for the design components refer to the set of the design parameters present in each selection criteria, and the positive and negative design component selection examples are the examples identified from the sub-set of positive design component objects and a sub-set of negative design component objects.

At step 306c, the one or more design component objects are selected out of the plurality of design component obj ects, using the component selection model and the instruction triplet generated at step 306b. The component selection model is a vision language model (also referred as a multi-modal language model) such as GPT-4O, which is used to identify the design components that are to be selected and not to be selected for the required design, based on the instruction triplet.

In an embodiment, the design component selector 204b of the design knowledge extractor 204 is configured to select the one or more design component objects out of the plurality of design component objects, based on the instruction triplet.

Some of the examples are explained below where the design components that are selected and not selected are listed for the interior design.

### Example 1-

Selected design components:
- Armchairs: The comfortable and visually appealing chairs and sofa contribute to usability and fit well with the design theme.
- Coffee table: The table's design is visually pleasing, with creative decorative items that inspire.
- Entertainment unit: Offers practical storage and a sleek design that enhances the room's aesthetics.
- Lighting: The recessed lights are practical and enhance the room's ambiance.

Not-selected design components:
- Curtains: they are not as visually striking or unique as other elements.
- Wall art: Though it adds color, it doesn't contribute to the usability or organization of the space.

### Example 2-

Selected design components:
- TV wall: The herringbone tile is a unique and creative element that adds a focal point without cluttering the space.
- Shelves: Provides practical storage and display, enhancing the room's aesthetics.
- Chandelier: The chandelier is an elegant touch that enhances the ambiance.

Not-selected design components:
- Flooring: it doesn't stand out as a unique design feature.
- Windows: doesn't align with the overall design theme.

### Example 3-

Selected design components:
- Dining table: Offers functionality with ample seating.
- Pendant lights: Adds visual interest without cluttering the space.
- Built-in bookshelves: Crafted from durable materials that ensure longevity.

Not-selected design components:
- Rug: the rug doesn't stand out in terms of creativity or uniqueness.
- Wall clock: lacks aesthetic appeal and does not contribute to the overall design theme.

### Example 4-

Selected design components:
- Office desk: Ergonomically designed to enhance comfort and productivity.
- Task chair: Provides excellent ergonomics and comfort.
- Indoor plants: Natural element that harmonizes with the office environment.

Not-selected design components:
- Curtains: they lack a unique design element and do not enhance the room's aesthetics.
- File cabinet: bulky, it adds to the visual clutter.

### Example 5-

Selected design components:
- Kitchen island: Its modern design and use of eco-friendly materials enhance both aesthetics and sustainability.
- Backsplash: This adds cultural relevance through its Mediterranean design influences.
- LED under-cabinet lighting: This contributes to energy efficiency.

Not-selected design components:
- Standard cabinetry: lacks unique design elements, making it less compelling in the overall design.
- Flooring: does not contribute to the room's creative or aesthetic appeal.

### Example 6-

Selected design components:
Ceramic tile flooring: Known for being affordable and long-lasting, it provides great value for the cost.
- Induction cooktop: Safety is enhanced as the cooktop surface remains cooler than traditional options, significantly reducing burn risks and eliminating open flames that could lead to fire hazards.
- Quartz countertops: These provide excellent cost-effectiveness due to their durability and low maintenance requirements.

Not-selected design components:
- Marble countertops: they are expensive and require frequent maintenance, reducing cost-effectiveness.
- Hardwood flooring: When wet, it can become slippery, increasing the risk of slips and falls, thus presenting safety issues.

At step 308 of the method 300, the one or more hardware processors 104 of the system 100 are configured to pre-process the one or more design component objects to obtain one or more pre-processed design component objects. One or more pre-processing techniques are employed to perform one or more pre-processing operations on the one or more design component objects to obtain one or more pre-processed design component objects. In an embodiment, the one or more pre-processing operations include but are not limited to outlier removal, duplicates removal, image filling, and so on.

At step 310 of the method 300, the one or more hardware processors 104 of the system 100 are configured to obtain one or more textual descriptions from the one or more pre-processed design component objects associated with the one or more design components. The one or more descriptions are the descriptions, or the captions of the design component objects in the textual form.

An image description model is employed along with a semantic filtering for obtaining one or more textual descriptions from the one or more pre-processed design component objects. FIG. 5 is a flowchart showing the steps for obtaining the one or more textual descriptions from the one or more pre-processed design component objects, in accordance with some embodiments of the present disclosure. As shown in FIG. 5, obtaining the one or more textual descriptions from the one or more pre-processed design component objects is explained through steps 310a to 310b.

At step 310a, a plurality of textual descriptions is generated from the one or more pre-processed design component objects, using the image description model. In an embodiment, the image description model is a blip image captioning model or any other caption generation model that can generate the image description in the textual form. The image description model may generate one or more descriptions for each pre-processed design component object so as to obtain the plurality of textual descriptions from the one or more pre-processed design component objects.

At step 310b, one or more textual descriptions associated with the one or more design components, are filtered out of the plurality of textual descriptions using the semantic filtering. The semantic filtering is a rule-based filtering that defines semantic filter guidelines and apply natural language processing (NLP) model techniques to remove duplicate words and meaningless words, correct the sentences in the captioned, complete words and sentences if any word or sentence is incomplete, and so on. More specifically the semantic filtering removes duplicates, cleans up the descriptions by removing certain unwanted words, and saves the cleaned data back to a given format, such as CSV file. In an embodiment, the semantic filter 204c of the design knowledge extractor 204 is configured to filter the one or more textual descriptions out of the plurality of textual descriptions.

In an embodiment, sequential steps in the semantic filtering are as follows:
- Import the library: The process starts by importing the relevant library for data manipulation and analysis.
- Load the CSV file: This step reads a CSV file and converts it into a data frame using a tool such as pandas. This data frame is a table-like structure that holds the data from the CSV file.
- Remove duplicate descriptions: The step removes any duplicate rows in the data frame based on the values in the 'description' column. This is done using drop_duplicates, resulting in a new data frame.
- List of words to remove: A list named meaningless_words is defined, containing words like 'arafed' and 'araffe'. These are words deemed unnecessary or irrelevant in the descriptions and are removed.
- Define a cleaning function: A cleaning function is defined, which takes a description as input, splits it into individual words, and removes any words that appear in the meaningless_words list. It then joins the remaining words back into a single string.
- Apply the cleaning function: The clean function is applied to the 'description' column of the data frame. This updates each description by removing the meaningless words.
- Save the cleaned data: Finally, the cleaned data frame (df_unique) is saved back to a new CSV file.

At step 312 of the method 300, the one or more hardware processors 104 of the system 100 are configured to generate a design component knowledge graph associated with the design, from the one or more textual descriptions. The design component knowledge graph is the knowledge graph that is generated from the one or more textual descriptions and thus the generated design component knowledge graph is of the design of which the plurality of design images is received at step 302 of the method 300.

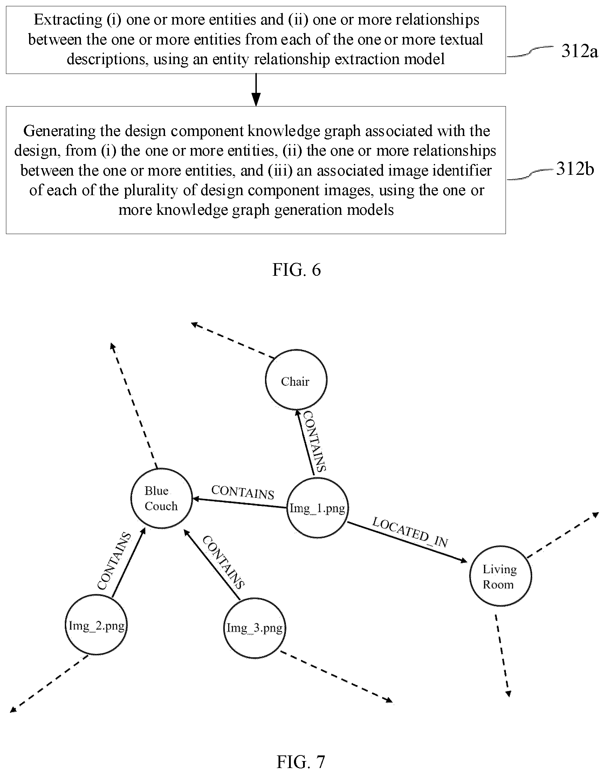

The one or more knowledge graph generation models are employed to generate the generate a design component knowledge graph from the one or more textual descriptions. FIG. 6 is a flowchart showing the steps for generating the design component knowledge graph associated with the design, from the one or more textual descriptions, in accordance with some embodiments of the present disclosure. As shown in FIG. 6, generating the design component knowledge graph from the one or more textual descriptions is explained through steps 312a to 312b.

At step 312a, (i) one or more entities, and (ii) one or more relationships between the one or more entities are extracted from each of the one or more textual descriptions. An entity relationship extraction model is employed which extracts one or more entities and their relationships. The one or more entities are the typically the one or more pre-processed design component objects and the one or more relationships are the relationships between the one or more pre-processed design component objects with respect to the corresponding design image. In an embodiment, the entity and relations extractor 206a of the knowledge graph generator and component retriever 206 is configured to extract the one or more entities, and the one or more relationships between the one or more entities.

At step 312b, the design component knowledge graph associated with the design is generated using the one or more entities, the one or more relationships between the one or more entities, and an associated image identifier of each of the plurality of design images. The associated image identifier refers to a unique identification of each design image. In an embodiment, the knowledge graph constructor 206b of the knowledge graph generator and component retriever 206 is configured to generate the design component knowledge graph associated with the design.

In the design component knowledge graph, the one or more entities and the associated image identifier are represented as nodes and the one or more relationships between them as represented as edges. The one or more knowledge graph generation models such as a language model transformer is used which reads the textual descriptions of different design components and converts them into graph formats. The process involves setting up a language transformer, preparing text documents, and then converting those documents into a graph structure.

For example, GPT4O (Large language model (LLM)) model using Azure OpenAI Service, is employed as the language model. This model takes the text, creates a document object, and then transforms this document into a graph structure with nodes and relationships. The language model uses its superior natural language processing capability to analyze the text and identify nodes/entities (like objects, places) and relationships between them. Further, the entities and the relationships can be annotated manually to create a more accurate and reliable knowledge graph. However, this option of using solely human annotation is labor-intensive, expensive and not scalable.

In an embodiment, the process steps for generating the design component knowledge graph are as follows:
- Import the LLMGraphTransformer: The LLMGraphTransformer class is imported from a module to convert text documents into a graph representation using a language model.
- Initialize the LLMGraphTransformer: An instance of the LLMGraphTransformer is created and stored in the variable LLM_transformer. This instance is initialized with a language model, referred to as LLM. The language model would typically be used to understand and process the text data.
- Import the document class: The document class is imported to generate a structure or to encapsulate text data in a way that the transformer can process.
- Create document instances: A list named documents is created, containing a single instance of the document class. This instance is initialized with some text content, stored in the variable text.
- Convert to graph documents: The convert_to_graph_documents technique of the LLM_transformer is called with the documents list as an argument. This technique processes the documents using the language model and converts them into a graph-based representation. The result is stored in the variable graph_documents.

In an embodiment, the graph representation (nodes and relationships) is added to a Neo4j database once they are obtained from the descriptions text to make a system that can store and manage graph data. Neo4j database is optimized for storing and querying interconnected data, making it ideal for knowledge graphs with complex relationships. It can handle large datasets and complex queries quickly. It provides tools for visualizing graph data, which can help in understanding and deriving insights from relationships.

FIG. 7 shows an exemplary design component knowledge graph generated for an exemplary interior design, in accordance with some embodiments of the present disclosure. As shown in FIG. 7, the design components such as chair, blue couch, living room, and their associated image identifiers are represented as nodes and their relationships such as 'contains', 'located in' are represented as edges in a partial design component knowledge graph.

At step 314 of the method 300, the one or more input/output (I/O) interfaces 106 of the system 100 are configured to receive an input query associated with the design from a user. The input query represents the requirement of the user for the design and the one or more design components that are most likely part of the design. The input query is one of a text, an image, and a combination thereof. **In an** embodiment, the input query is a multi-model input.

At step 316 of the method 300, the one or more hardware processors 104 of the system 100 are configured to transform the input query associated with the design into a transformed input query associated with the design component. A query transformation model is used to transform the input query into the transformed input query. In an embodiment, the query transformation model is a Cypher transformation model which is used to convert the input query into the Cypher format.

Cypher is a query language for the Neo4j graph database, designed to be intuitive and provide a powerful way to interact with graph data. It is used to perform operations such as querying, updating, and managing data within a graph database. Cypher uses a syntax similar to structured query language (SQL) but is optimized for handling graph structures, making it easier to express complex graph traversals and patterns.

At step 318 of the method 300, the one or more hardware processors 104 of the system 100 are configured to retrieve the one or more design component objects associated with the design which the user is interested in, from the design component knowledge graph, based on the transformed input query. The transformed input query such as the Cypher transformation query is run on the neo4j graph database (the knowledge graph) to retrieve the one or more design component objects associated with the design. In an embodiment, the design component retriever 206c of the knowledge graph generator and component retriever 206 is configured to retrieve the one or more design component objects associated with the design, from the design component knowledge graph.

The methods and systems of the present disclosure generate the design component knowledge graph from the textual descriptions of the selected design components by the user using the design requirement input. So, the design component knowledge graph is the customized knowledge graph which can re-generated based on the user requirement by changing the design requirement input. Thus, the user can retrieve the design components based on his interest from the design component knowledge graph by changing the design requirement input.

Conventional systems that specifically focused on the retrieval of design components using multimodal input (text/drawings/images) are very limited. Certain tools may offer limited multimodal search capabilities, but typically these are not integrated with graph databases or specifically tailored for design components retrieval. The methods and systems of the present disclosure combine multi-modal input with graph databases via Cypher queries, which is an efficient method for the retrieval, potentially distinguishing it from existing technologies.

Retrieval systems which rely solely on text-based queries, can be limiting for users/designers who think visually or when precise textual descriptions are challenging. By introducing multimodal retrieval, the methods and systems of the present disclosure allow users to leverage both language and visual sketches, providing a more comprehensive and intuitive search experience.

### Example Scenario:

The methods and systems of the present disclosure were validated for the interior design to study the accuracy of the retrieval of design components. A sample dataset consists of 300 design images of the interior design and around 1500 design component images associated with 50 design components. Among 1500 design component images, only 253 design component images were extracted by the design component detection model. The user requirement input was to get the familiar design components that mostly interior design should have in the hall/living area. The selection criterion considered was harmony plus sustainability. The instruction triplet was generated based on the selection criterion considered and the design component knowledge graph was constructed accordingly.

The design components retrieved from the constructed design component knowledge graph by the methods and systems of the present disclosure for the same given user requirement input were: (i) vase, (ii) flowers, (iii) potted plant, and (iv) coffee table. The design components chosen by a set of users for the given user requirement input were considered as the ground truth design components, and the design components chosen were: (i) vase with flowers, (ii) potted plant, and (iii) coffee table.

A set of validation metrics consists of (i) a precision, (ii) recall, and (iii) F1 score, were calculated based on the design components retrieved by the methods and systems of the present disclosure and the ground truth components chosen by the set of users, using true positives (TP), false positives (FP), false negatives (FN).
True Positives (TP): The design components that are correctly predicted (that they appear in both the ground truth design components and predicted lists) was considered
   - Potted plant (present in both actual and predicted components)
   - Coffee table (present in both actual and predicted components)
False Positives (FP): The design components that are predicted but do not appear in the ground truth design components was considered.
   - Vase
   - Flowers
False Negatives (FN): The design components that are in the ground truth design components but were not predicted are considered in this category.
   - Vase with flowers

Based on the true positives (TP), false positives (FP), and false negatives (FN), the set of validation metrics are calculated as follows. Precision measures the proportion of predicted design components that are correct.
- Number of true positives (TP): 2 (Potted plant, Coffee table)
- Number of false positives (FP): 2 (Vase, Flowers)
- Precision = TP/(TP+FP) = 2/(2+2) = 0.5
- Interpretation: Out of all the design components predicted, 50% were correct.

Recall measures the proportion of ground truth design components that were correctly predicted.
- Number of True Positives (TP): 2 (Potted plant, Coffee table)
- Number of False Negatives (FN): 1 (Vase with flowers)
- Recall = TP/(TP+FN) = 2/(2+1) = 0.67
- Interpretation: Correctly predicted approximately 66.67% of the components the user was looking for.

The F1 score is the harmonic mean of precision and recall, providing a balance between the two.
- F1 score = (2* precision*recall)/(precision+recall) =(2*0.5*0.67)/(0.5+0.67)= 0.57 = 57%
- Interpretation: The F1 score reflects the balance between precision and recall, indicating that overall, the system has a moderate performance in predicting the components.

Table. 1 shows the experimental results:

**Table. 1**

| Metrics | Score |
|---|---|
| Precision | 0.5 |
| Recall | 0.67 |
| F1 score | 0.57 |

The written description describes the subject matter herein to enable any person skilled in the art to make and use the embodiments. The scope of the subject matter embodiments is defined by the claims and may include other modifications that occur to those skilled in the art. Such other modifications are intended to be within the scope of the claims if they have similar elements that do not differ from the literal language of the claims or if they include equivalent elements with insubstantial differences from the literal language of the claims.

The embodiments of present disclosure herein address unresolved problems of generating the design component knowledge graph and design component retrieval from the same. Using the customized design component knowledge graph, the user or the customer can directly retrieve the relevant design components effectively and accurately based on the user requirement.

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an application-specific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means, and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computer-usable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items or meant to be limited to only the listed item or items. It must also be noted that as used herein and in the appended claims, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope of disclosed embodiments being indicated by the following claims.

## Claims

1. A processor-implemented method (300), comprising:
receiving, via one or more input/output (I/O) interfaces, a plurality of design images associated with a design, from a design image repository, wherein each of the plurality of design images comprises one or more design components (302);
extracting, via one or more hardware processors, a plurality of design component objects from the plurality of design images, using a design component detection model (304);
selecting, via the one or more hardware processors, one or more design component objects out of the plurality of design component objects based on a design requirement input, using a component selection model (306);
pre-processing, via the one or more hardware processors, the one or more design component objects to obtain one or more pre-processed design component objects, using one or more pre-processing techniques (308);
obtaining, via the one or more hardware processors, one or more textual descriptions from the one or more pre-processed design component objects associated with the one or more design components, using an image description model and a semantic filtering (310); and
generating, via the one or more hardware processors, a design component knowledge graph associated with the design, from the one or more textual descriptions, using one or more knowledge graph generation models (312).

2. The processor-implemented method (300) as claimed in claim 1, further comprising:
receiving, via the one or more input/output (I/O) interfaces, an input query associated with the design from a user, wherein the input query is one of a text, and an image (314);
transforming, via the one or more hardware processors, the input query associated with the design into a transformed input query associated with the design component, using a query transformation model (316); and
retrieving, via the one or more hardware processors, the one or more design component objects associated with the design, from the design component knowledge graph, based on the transformed input query (318).

3. The processor-implemented method (300) as claimed in claim 1, wherein selecting the one or more design component objects out of the plurality of design component objects based on the design requirement input, using the component selection model, comprises:
receiving the design requirement input associated with the design from a user, selection criteria, and an exemplary design component object set associated with the selection criteria (306a);
generating an instruction triplet associated to the design requirement input, based on the selection criteria and the exemplary design component objects set associated with the selection criteria, using a few-shot prompting and a large language model (LLM) (306b); and
selecting the one or more design component objects out of the plurality of design component objects, using the component selection model and the instruction triplet (306c).

4. The processor-implemented method (300) as claimed in claim 1, wherein obtaining the one or more textual descriptions from the one or more pre-processed design component objects associated with the one or more design components, using the image description model and the semantic filtering, comprises:
generating a plurality of textual descriptions from the one or more pre-processed design component objects, using the image description model (310a); and
obtaining the one or more textual descriptions associated with the one or more design components, out of the plurality of textual descriptions using the semantic filtering (310b).

5. The processor-implemented method (300) as claimed in claim 1, wherein generating the design component knowledge graph associated with the design, from the one or more textual descriptions, using the one or more knowledge graph generation models, comprises:
extracting (i) one or more entities and (ii) one or more relationships between the one or more entities from each of the one or more textual descriptions, using an entity relationship extraction model (312a); and
generating the design component knowledge graph associated with the design, from (i) the one or more entities, (ii) the one or more relationships between the one or more entities, and (iii) an associated image identifier of each of the plurality of design component images, using the one or more knowledge graph generation models (312b).

6. A system (100), comprising:
a memory (102) storing instructions;
one or more input/output (I/O) interfaces (106); and
one or more hardware processors (104) coupled to the memory (102) via the one or more I/O interfaces (106), wherein the one or more hardware processors (104) are configured by the instructions to:
receive, via the one or more I/O interfaces (106), a plurality of design images associated with a design, from a design image repository, wherein each of the plurality of design images comprises one or more design components;
extract a plurality of design component objects from the plurality of design images, using a design component detection model;
select one or more design component objects out of the plurality of design component objects based on a design requirement input, using a component selection model;
pre-process the one or more design component objects to obtain one or more pre-processed design component objects, using one or more pre-processing techniques;
obtain one or more textual descriptions from the one or more pre-processed design component objects associated with the one or more design components, using an image description model and a semantic filtering; and
generate a design component knowledge graph associated with the design, from the one or more textual descriptions, using one or more knowledge graph generation models.

7. The system (100) as claimed in claim 6, wherein the one or more hardware processors (104) are further configured by the instructions to:
receive, via the one or more I/O interfaces (106), an input query associated with the design from a user, wherein the input query is one of a text, and an image;
transform the input query associated with the design into a transformed input query associated with the design component, using a query transformation model; and
retrieve the one or more design component objects associated with the design, from the design component knowledge graph, based on the transformed input query.

8. The system (100) as claimed in claim 6, wherein the one or more hardware processors (104) are configured to select the one or more design component objects out of the plurality of design component objects based on the design requirement input, using the component selection model, by:
receiving the design requirement input associated with the design from a user, selection criteria, and an exemplary design component object set associated with the selection criteria;
generating an instruction triplet associated to the design requirement input, based on the selection criteria and the exemplary design component objects set associated with the selection criteria, using a few-shot prompting and a large language model (LLM); and
selecting the one or more design component objects out of the plurality of design component objects, using the component selection model and the instruction triplet.

9. The system (100) as claimed in claim 6, wherein the one or more hardware processors (104) are configured by the instructions to obtain the one or more textual descriptions from the one or more pre-processed design component objects associated with the one or more design components, using the image description model and the semantic filtering, by:
generating a plurality of textual descriptions from the one or more pre-processed design component objects, using the image description model; and
obtaining the one or more textual descriptions associated with the one or more design components, out of the plurality of textual descriptions using the semantic filtering.

10. The system (100) as claimed in claim 6, wherein the one or more hardware processors (104) are configured by the instructions to generate the design component knowledge graph associated with the design, from the one or more textual descriptions, using the one or more knowledge graph generation models, by:
extracting (i) one or more entities and (ii) one or more relationships between the one or more entities from each of the one or more textual descriptions, using an entity relationship extraction model; and
generating the design component knowledge graph associated with the design, from (i) the one or more entities, (ii) the one or more relationships between the one or more entities, and (iii) an associated image identifier of each of the plurality of design component images, using the one or more knowledge graph generation models.

11. One or more non-transitory machine-readable information storage mediums comprising one or more instructions which when executed by one or more hardware processors cause:
receiving, via one or more input/output (I/O) interfaces, a plurality of design images associated with a design, from a design image repository, wherein each of the plurality of design images comprises one or more design components;
extracting a plurality of design component objects from the plurality of design images, using a design component detection model;
selecting one or more design component objects out of the plurality of design component objects based on a design requirement input, using a component selection model;
pre-processing the one or more design component objects to obtain one or more pre-processed design component objects, using one or more pre-processing techniques;
obtaining one or more textual descriptions from the one or more pre-processed design component objects associated with the one or more design components, using an image description model and a semantic filtering; and
generating a design component knowledge graph associated with the design, from the one or more textual descriptions, using one or more knowledge graph generation models.

12. The one or more non-transitory machine readable information storage mediums as claimed in claim 11, wherein the one or more instructions which when executed by one or more hardware processors further cause:
receiving, via the one or more input/output (I/O) interfaces, an input query associated with the design from a user, wherein the input query is one of a text, and an image;
transforming the input query associated with the design into a transformed input query associated with the design component, using a query transformation model; and
retrieving the one or more design component objects associated with the design, from the design component knowledge graph, based on the transformed input query.

13. The one or more non-transitory machine readable information storage mediums as claimed in claim 11, wherein selecting the one or more design component objects out of the plurality of design component objects based on the design requirement input, using the component selection model, comprises:
receiving the design requirement input associated with the design from a user, selection criteria, and an exemplary design component object set associated with the selection criteria;
generating an instruction triplet associated to the design requirement input, based on the selection criteria and the exemplary design component objects set associated with the selection criteria, using a few-shot prompting and a large language model (LLM); and
selecting the one or more design component objects out of the plurality of design component objects, using the component selection model and the instruction triplet.

14. The one or more non-transitory machine readable information storage mediums as claimed in claim 11, wherein obtaining the one or more textual descriptions from the one or more pre-processed design component objects associated with the one or more design components, using the image description model and the semantic filtering, comprises:
generating a plurality of textual descriptions from the one or more pre-processed design component objects, using the image description model; and
obtaining the one or more textual descriptions associated with the one or more design components, out of the plurality of textual descriptions using the semantic filtering.

15. The one or more non-transitory machine readable information storage mediums as claimed in claim 11, wherein generating the design component knowledge graph associated with the design, from the one or more textual descriptions, using the one or more knowledge graph generation models, comprises:
extracting (i) one or more entities and (ii) one or more relationships between the one or more entities from each of the one or more textual descriptions, using an entity relationship extraction model; and
generating the design component knowledge graph associated with the design, from (i) the one or more entities, (ii) the one or more relationships between the one or more entities, and (iii) an associated image identifier of each of the plurality of design component images, using the one or more knowledge graph generation models.
